(19) Europäisches Patentamt / European Patent Office / Office européen des brevets

(11) **EP 3 317 681 B1**

(12) **FASCICULE DE BREVET EUROPEEN**

(45) Date de publication et mention de la délivrance du brevet:
**19.06.2019 Bulletin 2019/25**

(21) Numéro de dépôt: **16734261.7**

(22) Date de dépôt: **28.06.2016**

(51) Int Cl.:
*G01R 31/26* (2014.01)    *H05B 33/08* (2006.01)

(86) Numéro de dépôt international:
**PCT/EP2016/064943**

(87) Numéro de publication internationale:
**WO 2017/001370 (05.01.2017 Gazette 2017/01)**

(54) **PROCÉDÉ DE DÉTERMINATION D'UNE CAPACITÉ D'ÉMISSION DE LUMIÈRE D'UNE DIODE ÉLECTROLUMINESCENTE**

VERFAHREN ZUR BESTIMMUNG DER LEUCHTLEISTUNG EINER LEUCHTDIODE

METHOD FOR DETERMINING THE BRIGHTNESS OF A LIGHT EMITTING DIODE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.07.2015 FR 1556198**

(43) Date de publication de la demande:
**09.05.2018 Bulletin 2018/19**

(73) Titulaire: **Sagemcom Broadband SAS**
**92500 Rueil-Malmaison (FR)**

(72) Inventeur: **PELIN, Patrice**
**92500 Rueil Malmaison (FR)**

(74) Mandataire: **Cabinet Le Guen Maillet**
**3, impasse de la Vigie**
**CS 71840**
**35418 Saint-Malo Cedex (FR)**

(56) Documents cités:
**US-A1- 2014 074 434      US-A1- 2014 074 434**
**US-A1- 2014 225 511      US-A1- 2014 225 511**
**US-B2- 6 870 148         US-B2- 6 870 148**

EP 3 317 681 B1

## Description

L'invention concerne un procédé de détermination d'une capacité d'émission de lumière d'une diode électroluminescente, et un dispositif mettant en oeuvre ledit procédé.

Une diode électroluminescente (DEL, « Light-Emitting Diode (LED) » en terminologie anglo-saxonne), est un composant optoélectronique capable d'émettre de la lumière lorsqu'il est parcouru par un courant électrique. Une DEL comporte une cathode et une anode et ne laisse passer un courant électrique que dans un seul sens, dit sens direct ou sens passant, allant de l'anode vers la cathode. Lorsqu'elle est parcourue par un courant, une DEL produit un rayonnement monochromatique ou polychromatique non cohérent.

On parle de *polarisation directe* lorsqu'une différence de potentiel est appliquée à une DEL et que le potentiel appliqué sur l'anode est supérieur au potentiel de la cathode. Inversement, on parle de *polarisation inverse* lorsque la différence de potentiel appliquée à la DEL est telle que le potentiel appliqué sur la cathode est supérieur au potentiel appliqué sur l'anode. Seule une polarisation directe permet un passage de courant dans une DEL.

De nos jours, les DEL sont couramment utilisées pour de la signalisation, de l'affichage de données par exemple dans des écrans, ou pour de l'éclairage. Il est connu qu'au fur et à mesure de leur utilisation, les DEL subissent des phénomènes de vieillissement qui se concrétisent par une réduction d'une capacité d'émission de lumière desdites DEL. Par conséquent, plus une DEL est utilisée, plus sa capacité d'émission de lumière diminue. Par ailleurs, la capacité d'émission de lumière d'une DEL peut aussi être affectée par des salissures ou un empoussièrement accumulés au fil du temps.

Une réduction de la capacité d'émission de lumière d'une DEL peut avoir des conséquences fâcheuses. Par exemple, lorsqu'une DEL est utilisée pour de la signalisation, une réduction de la capacité d'émission de lumière de la DEL peut entraîner une mauvaise interprétation d'une information véhiculée par ladite DEL. Dans un autre contexte, lorsqu'une DEL est utilisé pour de l'éclairement, par exemple dans des phares d'un véhicule, une réduction de la capacité d'émission de lumière de la DEL peut entraîner des problèmes de sécurité.

Des méthodes existent pour déterminer la capacité d'émission de lumière d'une DEL. Dans une première méthode, des capteurs de lumière sont positionnés à proximité d'une DEL, afin de mesurer la capacité d'émission de lumière de la DEL. Introduire un capteur de lumière dans un dispositif comportant des DEL entraîne une augmentation de coût de fabrication dudit dispositif, qui peut être préjudiciable pour certains dispositifs bon marché. Par ailleurs, se posent de nombreux problèmes de mise en oeuvre tels que, par exemple, un problème de positionnement dudit capteur à une position judicieuse par rapport à la DEL pour ne pas gêner l'émission de lumière par la DEL, ou encore un problème de prise en compte d'un éclairage ambiant lorsque la DEL est soumise à un éclairage ambiant.

Dans une seconde méthode, la capacité d'émission de lumière d'une DEL est modélisée à l'aide d'un modèle mathématique, prenant par exemple en compte une durée d'utilisation de la DEL, un courant traversant la DEL et une température d'utilisation de la DEL. Toutefois, obtenir un modèle mathématique fiable est souvent difficile, car d'une part une DEL possède des caractéristiques dépendant de conditions de fabrication dans laquelle ladite DEL a été produite, et d'autre part, des paramètres non pris en compte dans le modèle mathématique (tels qu'un taux d'humidité, un rayonnement ultra-violet, une dégradation de matériaux composant la DEL) peuvent s'avérer pertinents pour caractériser une évolution dans le temps des capacités d'émission de lumière d'une DEL.

Il est souhaitable de pallier ces inconvénients de l'état de la technique.

Il est notamment souhaitable de proposer une méthode permettant de déterminer la capacité d'émission de lumière d'une DEL, qui soit simple à mettre en oeuvre et à faible coût. Il est aussi souhaitable de proposer une méthode permettant de compenser un phénomène de vieillissement d'une DEL.

Selon un premier aspect de la présente invention, la présente invention concerne un procédé de détermination d'une capacité d'émission de lumière d'une diode électroluminescente, dite DEL, ladite DEL comportant une cathode et une anode reliées à des ports d'un dispositif de contrôle appelés respectivement port cathode et port anode. Le procédé comprend les étapes suivantes: polariser la DEL en inverse de sorte à provoquer une accumulation d'une charge électrique par la DEL, ladite DEL étant soumise à une source de lumière incidente à la DEL; contrôler le port cathode et le port anode pour provoquer une décharge de la charge électrique accumulée par la DEL; obtenir une valeur représentative d'un temps de décharge de la charge de la DEL; déterminer la capacité d'émission de lumière de la DEL en fonction du temps de décharge obtenu.

De cette manière, on utilise des corrélations existant entre la capacité d'émission de lumière d'une DEL et son temps de décharge, qui est représentatif d'une capacité de captation de lumière de ladite DEL lorsqu'elle est polarisée en inverse.

Selon un mode de réalisation, simultanément au contrôle du port cathode et du port anode pour provoquer une décharge de la charge électrique accumulée par la DEL, un compteur est démarré, une valeur dudit compteur étant incrémentée périodiquement d'une unité avec une période prédéfinie tant qu'une tension mesurée entre l'anode et la cathode de la DEL est supérieure à une tension seuil prédéfinie, la valeur dudit compteur obtenue lorsque la tension mesurée entre l'anode et la cathode de la DEL devient inférieure ou égale à la tension seuil prédéfinie étant la valeur représentative d'un temps de décharge de la DEL.

Une méthode simple permettant de mesurer le temps de décharge d'une DEL et ainsi sa capacité d'émission de lumière est ainsi proposée.

Selon un mode de réalisation, une valeur de correction est appliquée à la valeur dudit compteur obtenue lorsque la tension mesurée entre l'anode et la cathode de la DEL devient inférieure ou égale à la tension seuil prédéfinie, ladite valeur dudit compteur après application de la valeur de correction étant la valeur représentative d'un temps de décharge de la DEL, la valeur de correction étant obtenue à partir d'une fonction de correction déterminée en faisant des mesures de capacité d'émission de lumière et des mesures de capacité de captation de lumière sur un ensemble de DEL prédéfini.

Selon un mode de réalisation, ladite valeur dudit compteur est initialisée à zéro à chaque polarisation en inverse de la DEL.

Selon un mode de réalisation, suite au démarrage du compteur, le compteur est arrêté si un temps écoulé depuis son démarrage atteint une valeur de temps prédéfinie.

Selon un mode de réalisation, le port cathode et le port anode sont des ports entrée/sortie logique, et la tension seuil prédéfinie est une tension de commutation du port cathode d'un état entrée vers un état sortie.

Selon un mode de réalisation, une procédure de correction est lancée en fonction de l'information représentative de la capacité d'émission de lumière de la DEL déterminée.

Selon un mode de réalisation, la procédure de correction signale à un opérateur que la DEL doit être remplacée.

Selon un mode de réalisation, la procédure de correction comprend : déterminer un courant à appliquer à la DEL lorsque la DEL est polarisée en direct, en fonction de la capacité d'émission de lumière de la DEL déterminée, et d'une capacité d'émission de lumière à atteindre ; et, appliquer le courant déterminé à la DEL lorsque la DEL est polarisée en sens direct.

Selon un deuxième aspect de l'invention, l'invention concerne un procédé pour homogénéiser une lumière émise par chaque DEL d'une pluralité de DEL d'un dispositif, chaque DEL comportant une cathode et une anode reliées à des ports d'un dispositif de contrôle, le procédé selon le premier aspect étant appliqué pour chaque DEL.

Selon un mode de réalisation, la capacité d'émission de lumière à atteindre est une capacité d'émission de lumière déterminée pour une des DEL de la pluralité de DEL, sélectionnée selon un critère prédéfini.

Selon un mode de réalisation, le critère prédéfini sélectionne la capacité d'émission de lumière déterminée la plus élevée parmi les capacités d'émission de lumière déterminées pour chaque DEL de la pluralité de DEL, ou la capacité d'émission de lumière déterminée la plus faible parmi les capacités d'émission de lumière déterminées pour chaque DEL de la pluralité de DEL, ou une capacité d'émission de lumière déterminée médiane parmi les capacités d'émission de lumière déterminées pour chaque DEL de la pluralité de DEL.

Selon un troisième aspect de l'invention, l'invention concerne un dispositif pour déterminer une capacité d'émission de lumière d'une diode électroluminescente, dite DEL, ladite DEL comportant une cathode et une anode reliées à des ports dudit dispositif appelé respectivement port cathode et port anode. Le dispositif comprend: des moyens de contrôle pour polariser la DEL en sens inverse de sorte à provoquer une accumulation d'une charge électrique par la DEL, ladite DEL étant soumise à une source de lumière incidente à la DEL ; des moyens de contrôle pour contrôler le port cathode et le port anode pour provoquer une décharge de la charge électrique accumulée par la DEL ; des moyens d'obtention pour obtenir une valeur représentative d'un temps de décharge de la charge de la DEL ; des moyens de détermination pour déterminer la capacité d'émission de lumière de la DEL en fonction du temps de décharge obtenu.

Selon un quatrième aspect de l'invention, l'invention concerne un programme d'ordinateur, comprenant des instructions pour mettre en oeuvre, par un dispositif, le procédé selon le premier ou le deuxième aspect, lorsque ledit programme est exécuté par un processeur dudit dispositif.

Selon un cinquième aspect de l'invention, l'invention concerne des moyens de stockage, stockant un programme d'ordinateur comprenant des instructions pour mettre en oeuvre, par un dispositif, le procédé selon le premier ou le deuxième aspect, lorsque ledit programme est exécuté par un processeur dudit dispositif.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1 illustre schématiquement un équipement dans lequel l'invention peut être mise en oeuvre ;
- la Fig. 2 illustre schématiquement un exemple d'architecture matérielle d'un dispositif de contrôle adapté pour la mise en oeuvre de l'invention. ;
- la Fig. 3 illustre schématiquement un exemple de connexion d'une DEL sur un processeur du dispositif de contrôle;
- la Fig. 4 illustre schématiquement un procédé détermination d'une capacité d'émission de lumière d'une DEL;
- la Fig. 5 illustre schématiquement une procédure de détermination d'une valeur représentative d'un temps de décharge d'une charge d'une DEL;
- la Fig. 6 illustre schématiquement une procédure de traitement d'une information de capacité d'émission de lumière d'une diode électroluminescente ;

- la Fig. 7A illustre schématiquement un premier exemple de procédure de correction d'une capacité d'émission de lumière d'une DEL ; et,
- la Fig. 7B illustre schématiquement un deuxième exemple de procédure de correction d'une capacité d'émission de lumière d'au moins une DEL ;

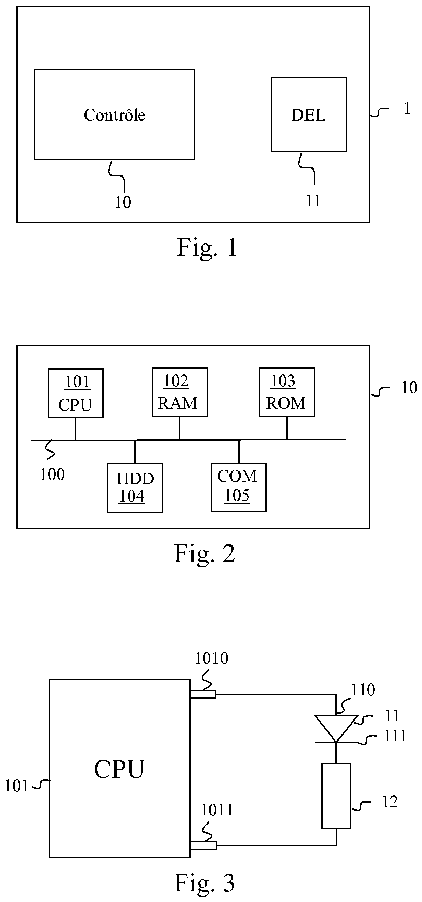

La **Fig. 1** illustre schématiquement un équipement 1 dans lequel l'invention peut être mise en oeuvre. L'équipement 1 comprend un dispositif de contrôle 10 et au moins une DEL 11. Chaque DEL 11 est reliée au dispositif de contrôle 10, de sorte que chaque DEL 11 est contrôlée par le dispositif de contrôle 10. Le dispositif de contrôle 10 contrôle notamment l'émission de lumière par chaque DEL 11.

La **Fig. 2** illustre schématiquement un exemple d'architecture matérielle du dispositif de contrôle 10.

Selon l'exemple d'architecture matérielle représenté à la Fig. 2, le dispositif de contrôle 10 comprend alors, reliés par un bus de communication 100 : un processeur ou CPU (« Central Processing Unit » en anglais) 101 ; une mémoire vive RAM (« Random Access Memory» en anglais) 102 ; une mémoire morte ROM (« Read Only Memory » en anglais) 103 ; une unité de stockage telle qu'un disque dur ou un lecteur de support de stockage, tel qu'un lecteur de cartes SD (« Secure Digital » en anglais) 104 ; au moins une interface de communication 105 permettant au dispositif de contrôle 10 de communiquer avec d'autres dispositifs, tels que par exemple des dispositifs de communication, pour transmettre une information représentative d'une capacité d'émission de lumière d'une DEL.

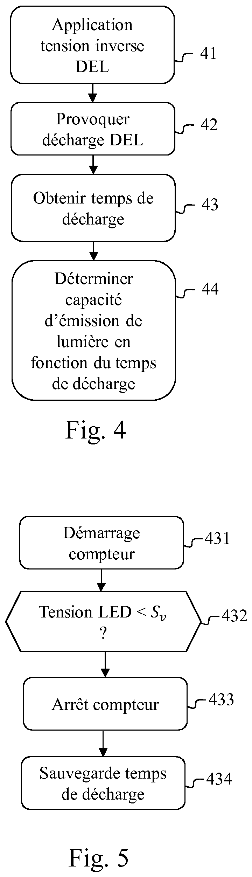

Le processeur 101 est capable d'exécuter des instructions chargées dans la RAM 102 à partir de la ROM 103, d'une mémoire externe (non représentée), d'un support de stockage (tel qu'une carte SD), ou d'un réseau de communication. Lorsque l'équipement 1 est mis sous tension (et donc lorsque le dispositif de contrôle 10 est mis sous tension), le processeur 101 est capable de lire de la RAM 102 des instructions et de les exécuter. Ces instructions forment un programme d'ordinateur causant la mise en oeuvre, par le processeur 101, des procédés décrits ci-après en relation avec les Figs. 4, 5, 6, 7A et 7B.

Le procédé décrit en relation avec les Figs. 4, 5, 6, 7A et 7B peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais).

La **Fig. 3** illustre schématiquement un exemple de connexion d'une DEL 11 sur un processeur 101 du dispositif de contrôle 10. La DEL 11 comporte une anode 110 et une cathode 111. L'anode 110 est reliée à un port 1010 du processeur 101, dit port anode, alors que la cathode 111 est reliée à un port 1011 du processeur 101, dit port cathode. Une résistance 12 est positionnée en série entre la cathode 111 et le port 1011. Le port anode 1010 et le port cathode 1011 sont des ports entrée/sortie logiques pouvant être commutés alternativement dans un état entrée, dans un état sortie, à des potentiels prédéfinis ou en tant que source de courant.

Lorsque la DEL 11 doit émettre de la lumière, une différence de potentiel est appliquée à la DEL 11 telle que le potentiel de l'anode 110 est supérieur au potentiel de la cathode 111. Dans ce cas, le DEL 11 est polarisée en direct.

On note que dans ce mode de réalisation, la DEL 11 est connectée directement sur le processeur 101 du dispositif de contrôle 10. Dans un autre mode de réalisation, la DEL 11 peut être connectée à des ports entrée/sortie logiques du dispositif de contrôle 10 indépendants du processeur 101 mais contrôlés par le processeur 101.

La **Fig. 4** illustre schématiquement un procédé détermination d'une capacité d'émission de lumière d'une diode électroluminescente. Le procédé décrit en relation avec la Fig. 4 est appliqué à la DEL 11.

Le procédé de la Fig. 4 est basé sur une caractéristique générale des DEL qui est qu'une DEL polarisée en inverse se comporte approximativement comme un condensateur ayant une capacité C dépendante d'une lumière incidente perçue par la DEL. Cette caractéristique permet d'utiliser une DEL comme un capteur de lumière. Par ailleurs, il est considéré dans l'invention que la capacité d'émission de lumière d'une DEL lorsqu'elle est polarisée en direct, est proportionnelle à une capacité de captation de lumière de ladite DEL lorsqu'elle est polarisée en inverse. Ainsi, il est considéré que lorsque la capacité d'émission de lumière d'une DEL varie du fait d'un vieillissement de ladite DEL, la capacité de captation de lumière de ladite DEL varie de la même manière. Par conséquent, l'invention consiste à obtenir une information représentative de la capacité de captation de lumière d'une DEL pour en dériver une information représentative de la capacité d'émission de lumière de ladite DEL.

Dans une étape 41, le dispositif de contrôle 10 polarise la DEL 11 en inverse de sorte à provoquer une accumulation d'une charge électrique par la DEL. Durant la polarisation, la DEL 11 est soumise à une source de lumière incidente. La lumière incidente est par exemple une lumière ambiante environnant l'équipement 1. La polarisation en inverse de la DEL 11 se fait pendant une durée allant de quelques millisecondes à plusieurs secondes.

Dans une étape 42, le dispositif de contrôle 10 contrôle le port anode 1010 et le port cathode 1011 pour provoquer une décharge de la charge électrique accumulée par la DEL 11. Pour ce faire, le port cathode 1011 est commuté en entrée. La décharge de la charge électrique de la DEL 11 se comporte comme une décharge d'un condensateur de capacité C. Une tension $U(t)$ entre l'anode et la cathode de la LED 11 en cours de décharge est donnée par l'équation suivante :

$$U(t) = U_{max} e^{-\frac{t}{RC}}$$

où $R$ est une valeur de résistance d'entrée du port cathode 1011, $t$ est une variable représentant des variations de temps et $U_{max}$ est une tension maximum entre l'anode et la cathode de la DEL 11 au début de la décharge.

Dans une étape 43, le dispositif de contrôle 10 obtient une valeur $N_D$ représentative d'un temps de décharge de la charge de la DEL 11, selon un procédé décrit en relation avec la Fig. 5. Le temps de décharge d'une DEL est représentatif de la capacité de captation de lumière de ladite DEL 11. Ainsi, un temps de décharge d'une DEL élevé indique que ladite DEL a une faible capacité de captation de lumière. Inversement, un temps de décharge d'une DEL faible indique que ladite DEL a une capacité de captation de lumière élevée.

Dans une étape 44, le dispositif de contrôle 10 détermine la capacité d'émission de lumière de la DEL 11 en fonction du temps de décharge obtenu. Dans un mode de réalisation, la valeur $N_D$, représentative du temps de décharge obtenue, est comparée à une valeur $N_D^{REF}$, représentative d'un temps de décharge de référence.

Dans un mode de réalisation la valeur $N_D^{REF}$ représentative d'un temps de décharge de référence a été obtenue lors d'une première mise sous tension de l'équipement 1. On suppose ici que lors de la première mise sous tension de l'équipement 1, la DEL 11 n'a pas encore subi de vieillissement et que par conséquent, sa capacité d'émission de lumière (et donc sa capacité de captation de lumière) est maximale. Afin de quantifier une réduction de la capacité d'émission de lumière (et donc sa capacité de captation de lumière) de la DEL 11, le module de contrôle calcule un pourcentage P à partir de la valeur $N_D$ représentative du temps de décharge obtenue, et la valeur $N_D^{REF}$ représentative d'un temps de décharge de référence :

$$P = \frac{N_D^{REF}}{N_D} \times 100$$

Par conséquent, à partir de chaque mesure de la valeur $N_D$ représentative du temps de décharge de la DEL 11, le dispositif de contrôle 10 est capable de déterminer que la capacité d'émission de lumière de la DEL 11 est égale à P % de sa capacité d'émission de lumière maximale. Le pourcentage P est donc représentatif de la capacité d'émission de lumière de la DEL 11.

Dans un mode de réalisation dans lequel l'équipement 1 comprend une pluralité de DEL 11, les étapes 41, 42 et 43 du procédé décrit en relation avec la Fig. 4 sont mises en oeuvre pour chaque DEL de la pluralité de DEL 11. Une valeur $N_D$ représentative du temps de décharge est obtenue pour chaque DEL de la pluralité de DEL 11. Lorsque les étapes 41, 42 et 43 ont été mises en oeuvre pour chaque DEL de la pluralité de DEL 11, la valeur $N_D^{REF}$ représentative d'un temps de décharge de référence est déterminée. Dans ce mode de réalisation, la valeur $N_D^{REF}$, représentative d'un temps de décharge de référence utilisée dans l'étape 44, est la valeur la plus faible parmi les valeurs $N_D$, représentatives du temps de décharge obtenues. On considère ici que la DEL de la pluralité de DEL 11 ayant la valeur $N_D$ représentative du temps de décharge la plus faible, est la DEL la moins affectée par un vieillissement. Le dispositif de traitement calcule alors, de la même manière que précédemment, pour chaque DEL de la pluralité de DEL 11, un pourcentage P.

Par conséquent, à partir de chaque mesure de chaque valeur $N_D$ représentative du temps de décharge d'une DEL de la pluralité de DEL 11, le dispositif de contrôle 10 est capable de déterminer que la capacité d'émission de lumière de chaque DEL de la pluralité de DEL 11 est égale à P % de la capacité d'émission de lumière de la DEL de la pluralité de DEL 11 la moins affectée par un vieillissement. Le pourcentage P est donc représentatif de la capacité d'émission de lumière de chaque DEL de la pluralité de DEL 11.

Dans un autre mode de réalisation dans lequel l'équipement 1 comprend une pluralité de DEL 11, les étapes 41, 42 et 43 du procédé décrit en relation avec la Fig. 4 sont mises en oeuvre pour chaque DEL de la pluralité de DEL 11. Une valeur $N_D$ représentative du temps de décharge est obtenue pour chaque DEL de la pluralité de DEL 11. Lorsque les étapes 41, 42 et 43 ont été mises en oeuvre pour chaque DEL de la pluralité de DEL 11, la valeur $N_D^{REF}$ représentative d'un temps de décharge de référence est déterminée. Dans ce mode de réalisation la valeur $N_D^{REF}$, représentative d'un temps de décharge de référence utilisée dans l'étape 44, est la valeur la plus élevée parmi les valeurs $N_D$ représentatives du temps de décharge obtenues. On considère ici que la DEL de la pluralité de DEL 11 ayant la valeur $N_D$ représentative du temps de décharge la plus élevée, est la DEL la plus affectée par un vieillissement. Le dispositif de traitement calcule alors, de la même manière que précédemment, pour chaque DEL de la pluralité de DEL 11, un pourcentage P.

Par conséquent, à partir de chaque mesure de chaque valeur $N_D$ représentative du temps de décharge d'une DEL de la pluralité de DEL 11, le dispositif de contrôle 10 est capable de déterminer que la capacité d'émission de lumière de chaque DEL de la pluralité de DEL 11 est égale à $P$ % de la capacité d'émission de lumière de la DEL de la pluralité de DEL 11 la plus affectée par un vieillissement.

Dans un autre mode de réalisation dans lequel l'équipement 1 comprend une pluralité de DEL 11, les étapes 41, 42 et 43 du procédé décrit en relation avec la Fig. 4 sont mises en oeuvre pour chaque DEL de la pluralité de DEL 11. Une valeur $N_D$ représentative du temps de décharge est obtenue pour chaque DEL de la pluralité de DEL 11. Lorsque les étapes 41, 42 et 43 ont été mises en oeuvre pour chaque DEL de la pluralité de DEL 11, la valeur $N_D^{REF}$ représentative d'un temps de décharge de référence est déterminée. Dans ce mode de réalisation, la valeur $N_D^{REF}$ représentative d'un temps de décharge de référence utilisée dans l'étape 44 est une valeur médiane parmi les valeurs $N_D$ représentatives du temps de décharge obtenues. Le dispositif de traitement calcule alors, de la même manière que précédemment, pour chaque DEL de la pluralité de DEL 11, un pourcentage $P$.

Par conséquent, à partir de chaque mesure de chaque valeur $N_D$ représentative du temps de décharge d'une DEL de la pluralité de DEL 11, le dispositif de contrôle 10 est capable de déterminer que la capacité d'émission de lumière de chaque DEL de la pluralité de DEL 11 est égale soit à $P$ % de la capacité d'émission de lumière d'une DEL de la pluralité de DEL 11 ayant une luminosité médiane.

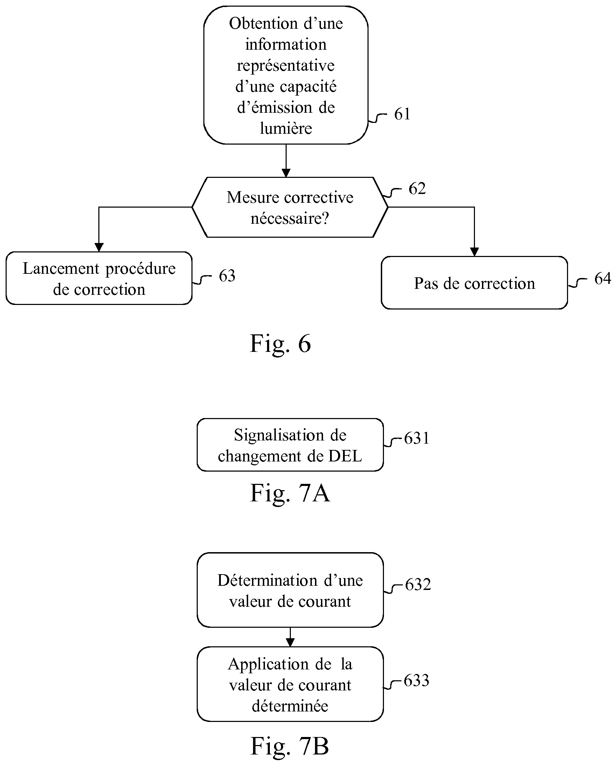

Chaque pourcentage P calculé est mémorisé par le dispositif de contrôle 10 en vue d'une utilisation ultérieure que nous décrivons en relation avec les Figs. 6, 7A et 7B.

On note que pour fiabiliser chaque mesure de capacité de captation de lumière, et pour pouvoir comparer différentes mesures de capacité de captation de lumière entre elles, il est préférable que chaque mise en oeuvre du procédé décrit en relation avec la Fig. 4 soit effectuée à lumière incidente constante. Dans un mode de réalisation, lors de chaque mise en oeuvre du procédé décrit en relation avec la Fig. 4, l'équipement 1 est soumis à une même source lumineuse produisant une lumière incidente constante. De cette manière, chaque DEL 11 de l'équipement 1 est toujours soumise à une même lumière incidente lors de chaque mise en oeuvre du procédé décrit en relation avec la Fig. 4.

Dans un mode de réalisation, un capteur de lumière situé au voisinage de l'équipement 1, est connecté au dispositif de contrôle 10 et lui transmet des mesures de la lumière ambiante. Le dispositif de contrôle 10 déclenche le procédé décrit en relation avec la Fig. 4 uniquement lorsque le capteur de lumière transmet une mesure de lumière ambiante égale à une valeur prédéfinie, ce qui permet d'assurer que chaque DEL de l'équipement 1 reçoit une lumière incidente constante.

Dans un mode de réalisation, adapté au cas où l'équipement 1 comprend une pluralité de DEL 11, un capteur de lumière situé au voisinage de l'équipement 1, est connecté au dispositif de contrôle 10 et lui transmet des mesures de la lumière ambiante. En utilisant les mesures de lumière ambiante, le dispositif de contrôle 10 s'assure que chaque DEL de la pluralité de DEL 11 a été soumise à une même lumière incidente pendant chaque mise en oeuvre du procédé décrit en relation avec la Fig. 4. De cette manière, le dispositif de contrôle 10 s'assure que les valeurs $N_D$ représentatives du temps de décharge de chaque DEL de la pluralité de DEL 11 peuvent être comparées entre elles puisque chaque DEL de la pluralité de DEL 11 a été soumise à une même lumière incidente. Si le dispositif de contrôle constate que toutes les DEL de la pluralité de DEL 11 n'ont pas reçu une lumière incidente identique, il considère que les mesures les valeurs $N_D$ représentatives du temps de décharge de chaque DEL de la pluralité de DEL 11 obtenues ne sont pas valides. Aucune mesure corrective n'est alors prise. Dans ce mode de réalisation, le capteur de lumière pourrait être une des DEL de l'équipement 1, comme par exemple, la DEL la moins utilisée, et donc la DEL ayant subi le moins de vieillissement.

La **Fig. 5** illustre schématiquement une procédure de détermination d'une valeur représentative d'un temps de décharge d'une charge d'une diode électroluminescente. Cette procédure correspond à un exemple de mise en oeuvre de l'étape 43 décrite en relation avec la Fig. 4. Cette procédure est mise en oeuvre pour chaque DEL 11 de l'équipement 1.

Dans une étape 431, simultanément à la commutation du port cathode 1011 dans l'état entrée, le dispositif de contrôle 10 démarre un compteur. Suite au démarrage du compteur, une valeur du compteur est incrémentée d'une unité à intervalles réguliers prédéfinis (*i.e.* avec une période prédéfinie) tant qu'une tension mesurée entre l'anode 110 et la cathode 111 de la DEL 11 est supérieure à une tension seuil prédéfinie $S_V$. La période prédéfinie peut prendre des valeurs de l'ordre d'une dizaine de microsecondes à quelques millisecondes. La période prédéfinie peut être adaptée à une intensité de la source de lumière incidente à la DEL 11. Plus ladite intensité est forte, plus le temps de décharge de la DEL 11 est faible et donc plus la période prédéfinie doit être courte. Inversement, plus ladite intensité est faible, plus le temps de décharge de la DEL 11 est long et donc plus la période prédéfinie peut être allongée. Dans un mode de réalisation, la tension seuil prédéfinie $S_V$ est une tension de commutation du port cathode 1011 de l'état entrée vers l'état sortie. On note que la valeur du compteur incrémentée est réinitialisée à la valeur zéro à chaque polarisation inverse de la DEL 11. Dans l'exemple de la Fig. 4, la valeur du compteur a donc été réinitialisée à zéro lors de l'étape 41.

Dans une étape 432, le dispositif de contrôle 10 vérifie, à intervalles réguliers correspondant par exemple à la période prédéfinie, si la tension mesurée entre l'anode 110 et la cathode 111 de la DEL 11 est inférieure à la tension seuil prédéfinie $S_v$. Lorsque la tension mesurée entre l'anode 110 et la cathode 111 de la DEL 11 devient inférieure à la tension seuil prédéfinie $S_v$, le dispositif de contrôle 10 met en oeuvre une étape 433.

Lors de l'étape 433, le dispositif de contrôle 10 arrête le compteur. La valeur prise par le compteur lors de l'arrêt correspond à la valeur $N_D$ représentative du temps de décharge de la DEL 11.

Lors d'une étape 434, le dispositif de contrôle 10 sauvegarde la valeur $N_D$ représentative du temps de décharge de la DEL 11.

Dans un mode de réalisation, l'étape 432, au cours de laquelle le dispositif de contrôle 10 vérifie si la tension mesurée entre l'anode 110 et la cathode 111 de la DEL 11 est inférieure à la tension seuil prédéfinie $S_v$, est mise en oeuvre pendant une durée limitée $T_o$ correspondant à une valeur de compteur $N_o$. Un objectif de ce mode de réalisation est de ne pas prolonger une mesure de la valeur représentative du temps de décharge pour une DEL 11 indéfiniment, ce qui nuirait au bon fonctionnement de l'équipement 1. Deux raisons peuvent expliquer que le temps de décharge d'une DEL soit long : soit ladite DEL a subi un vieillissement tel que sa capacité d'émission de lumière est quasi nulle, soit ladite DEL est soumise à une lumière ambiante trop faible pour effectuer une mesure fiable. Dans ce cas, le compteur est arrêté lorsqu'il atteint la valeur de compteur $N_D = N_o$. Si la valeur de compteur $N_o$ est atteinte sans que la tension mesurée entre l'anode 110 et la cathode 111 de la DEL 11 soit inférieure à la tension seuil prédéfinie $S_v$, la valeur de compteur $N_D = N_o$ est sauvegardé lors de l'étape 434.

Dans un mode réalisation, la durée limitée $T_o$ peut aussi être définie en fonction d'une gêne que pourrait occasionner une mise en oeuvre du procédé décrit en relation avec la Fig. 4. Par exemple, lorsque, dans un fonctionnement normal, la DEL 11 doit émettre constamment une lumière, il est préférable que la DEL 11 soit éteinte pendant une durée courte pour éviter que l'extinction de ladite DEL 11 soit interprétée comme un dysfonctionnement de ladite DEL 11 ou de l'équipement 1. Dans un mode de réalisation, on considère que la capacité d'émission de lumière d'une DEL lorsqu'elle est polarisée en direct, est corrélée à la capacité de captation de lumière de ladite DEL lorsqu'elle est polarisée en inverse, sans être directement proportionnelle à la capacité de captation de lumière de ladite DEL lorsqu'elle est polarisée en inverse. Il est nécessaire dans ce cas de corriger la valeur de compteur $N_D$ obtenue afin d'obtenir une valeur de compteur corrigée $N_D^{Corr}$ représentative d'une capacité de captation de lumière de ladite DEL. Dans un mode de réalisation, la valeur de compteur corrigée $N_D^{Corr}$ est obtenue en appliquant une valeur de correction $V_{Corr}$ à la valeur de compteur $N_D$.

$$N_D^{Corr} = V_{Corr} \times N_D$$

La valeur de correction $V_{Corr}$ est obtenue à partir d'une fonction de correction $F$ telle que :

$$V_{Corr} = F(N_D) = A \times N_D$$

où A est une constante déterminée en faisant des mesures de capacité d'émission de lumière et des mesures de capacité de captation de lumière, sur un ensemble de DEL ayant subi des vieillissement variables. Lorsque la valeur de compteur $N_D$ a été corrigée, la valeur de compteur $N_D$ est remplacée par la valeur de compteur $N_D^{Corr}$.

La **Fig.6** illustre schématiquement une procédure de traitement d'une information de capacité d'émission de lumière d'une DEL. Un objectif de la procédure décrite en relation avec la Fig. 6 est d'utiliser l'information de capacité d'émission de lumière d'une DEL obtenue en utilisant le procédé décrit en relation avec la Fig. 4, pour appliquer des mesures de correction aux DEL ayant subi un vieillissement. La procédure décrite en relation avec la Fig. 6 est mise en oeuvre pour chaque DEL 11 de l'équipement 1.

Dans une étape 61, le dispositif de contrôle 10 obtient le pourcentage $P$ représentatif de la capacité d'émission de lumière de la DEL 11. Ce pourcentage $P$ est récupéré dans l'unité de stockage 104 du dispositif de contrôle 10 dans laquelle il a préalablement été stocké.

Dans une étape 62, le dispositif de contrôle 10 détermine si des mesures correctives sont à appliquer à ladite DEL. Dans un mode de réalisation, le dispositif de contrôle 10 vérifie si le pourcentage $P$ est compris dans une ensemble de valeur prédéfini :

$$P \in [100 - \varepsilon; 100 + \varepsilon]$$

où $\varepsilon$ est une constante par exemple égale à 30%.

Si le pourcentage $P$ est compris dans l'ensemble de valeurs prédéfini, le dispositif de contrôle 10 met en oeuvre une étape 64. Lors de l'étape 64, le dispositif de contrôle 10 décide qu'aucune procédure de correction n'est à mettre en oeuvre.

Si le pourcentage $P$ est en dehors de l'ensemble de valeurs prédéfini, le dispositif de contrôle 10 met en oeuvre une étape 63. Lors de l'étape 63, le dispositif de contrôle 10 met en oeuvre une procédure de correction.

On note donc que la procédure de correction est lancée en fonction de la capacité d'émission de lumière de la DEL représenté par le pourcentage $P$ déterminé.

Dans un mode de réalisation adapté au cas où l'équipement 1 comprend une pluralité de DEL 11, le dispositif de contrôle 10 obtient pour chaque DEL de la pluralité de DEL 11, un pourcentage $P$ et une valeur de compteur $N_D$. Lorsque toutes les valeurs de compteur $N_D$ obtenues sont égales à la valeur de compteur $N_o$, le dispositif de contrôle 10 considère que la lumière incidente reçue par les DEL de la pluralité de DEL 11 était insuffisante pour obtenir des mesures de capacité de captation de lumière fiables. Dans ce cas, aucune procédure de correction n'est mise en oeuvre. Si, par contre, au moins une des valeurs de compteur $N_D$ obtenue n'est pas égale à la valeur de compteur $N_o$, les mesures de capacité de captation de lumière sont considérées fiables.

La **Fig. 7A** illustre schématiquement un premier exemple de procédure de correction d'une capacité d'émission d'une diode électroluminescente. La procédure de correction décrite en relation avec la Fig. 7A est mise en oeuvre lors de l'étape 63.

Dans une étape 631, le dispositif de traitement 10 déclenche une procédure de signalisation indiquant que la DEL 11 doit être remplacée. Un objectif de la procédure de signalisation est d'informer un opérateur en charge d'une maintenance de l'équipement 1, que la DEL 11 doit être remplacée. Dans un mode de réalisation, le dispositif de contrôle 10 envoie un message à l'opérateur en utilisant l'interface de communication 105. Le message indique à l'opérateur que la DEL 11 doit être remplacée.

La **Fig. 7B** illustre schématiquement un deuxième exemple de procédure de correction d'une capacité d'émission de lumière d'une DEL. La procédure de correction décrite en relation avec la Fig. 7B est mise en oeuvre lors de l'étape 63. Un objectif de la procédure décrite en relation avec la Fig. 7B est de permettre au dispositif de contrôle 10 de contrôler un courant traversant la DEL 11, afin de compenser le vieillissement de ladite DEL 11, ou lorsque l'équipement 1 comporte une pluralité de DEL 11, de rééquilibrer l'éclairement fourni par les DEL de la pluralité de DEL 11.

Dans une étape 632, le dispositif de contrôle 10 détermine un courant corrigé $I_{corr}$ à appliquer à la DEL 11 lorsqu'une polarisation directe est appliquée à la DEL 11. Le courant corrigé $I_{corr}$ à appliquer est déterminé en fonction de la capacité d'émission de lumière de la DEL, représenté par le pourcentage $P$ déterminé, et d'une capacité d'émission de lumière à atteindre. Dans un mode de réalisation, la capacité d'émission de lumière à atteindre est la capacité d'une DEL associée à la valeur $N_D^{REF}$ représentative d'un temps de décharge de référence.

Lorsque l'équipement 1 ne comporte qu'une DEL 11, la DEL associée à la valeur $N_D^{REF}$ représentative d'un temps de décharge de référence est la DEL 11 elle-même. Dans ce cas, la valeur $N_D^{REF}$ représentative d'un temps de décharge de référence, est la valeur de temps de décharge obtenue lors de la première mise sous tension de l'équipement 1, lorsque la DEL 11 n'avait pas subi de vieillissement.

On considère alors lors de l'étape 632 que lorsque la capacité d'émission de lumière de la DEL 11 est égale à P % de sa capacité d'émission de lumière maximale, il faut augmenter de (1/P)% le courant traversant la DEL 11 par rapport au courant $I$ ayant traversé la DEL 11 lors de la première mise sous tension. Le courant corrigé $I_{corr}$ est alors égale à :

$$I_{corr} = (1/P) \times I$$

Dans une étape 633, le dispositif de contrôle 10 applique à la DEL 11, le courant corrigé $I_{corr}$ déterminé.

Dans un mode de réalisation adapté à un cas ou l'équipement 1 comporte une pluralité de DEL 11, le dispositif de traitement 10 applique le procédé décrit en relation avec la Fig. 7B à chaque DEL de la pluralité de DEL 11.

Dans un autre mode de réalisation adapté à un cas ou l'équipement 1 comporte une pluralité de DEL 11, la DEL de la pluralité de DEL 11 associée à la valeur $N_D^{REF}$ représentative d'un temps de décharge de référence est, soit la DEL ayant la capacité d'émission de lumière la plus élevée parmi les DEL de la pluralité de DEL 11, soit la DEL ayant la capacité d'émission de lumière la plus faible parmi les DEL de la pluralité de DEL 11, soit une DEL ayant une capacité d'émission de lumière médiane parmi les DEL de la pluralité de DEL 11. Un objectif de ce mode de réalisation est d'homogénéiser la lumière émise de sorte que chaque DEL de la pluralité de DEL émette une luminosité identique. Le dispositif de traitement 10 applique le procédé décrit en relation avec la Fig. 7B à chaque DEL de la pluralité de DEL 11. Lors de la mise en oeuvre de l'étape 632 pour une DEL de la pluralité de DEL 11, une valeur de courant corrigée est déterminée pour ladite DEL de la pluralité de DEL 11 en utilisant le pourcentage $P$ déterminé pour ladite DEL :

$$I_{corr} = (1/P) \times I_{ref}$$

Dans ce cas, $I_{ref}$ est une valeur de courant traversant la DEL de la pluralité de DEL 11, associée à la valeur $N_D^{REF}$ lors de la dernière mise en oeuvre de la procédure décrite en relation avec la Fig. 5.

**Revendications**

1. Procédé de détermination d'une capacité d'émission de lumière d'une diode électroluminescente (11), dite DEL, ladite DEL (11) comportant une cathode (111) et une anode (110) reliées à des ports d'un dispositif de contrôle (10) appelés respectivement port cathode (1011) et port anode (1010), **caracté-**

risé en ce que le procédé comprend les étapes suivantes :

polariser (41) la DEL (11) en inverse de sorte à provoquer une accumulation d'une charge électrique par la DEL (11), ladite DEL étant soumise à une source de lumière incidente à la DEL (11) ; contrôler le port cathode (1011) et le port anode (1010) pour provoquer (42) une décharge de la charge électrique accumulée par la DEL (11) ; obtenir (43) une valeur représentative d'un temps de décharge de la charge de la DEL (11) ; déterminer (44) la capacité d'émission de lumière de la DEL (11) en fonction du temps de décharge obtenu.

2. Procédé selon la revendication 1, **caractérisé en ce que** simultanément au contrôle du port cathode (1011) et du port anode (1010) pour provoquer une décharge de la charge électrique accumulée par la DEL 11, un compteur est démarré (431), une valeur dudit compteur étant incrémentée périodiquement d'une unité avec une période prédéfinie tant qu'une tension mesurée entre l'anode (110) et la cathode (111) de la DEL (11) est supérieure à une tension seuil prédéfinie (432), la valeur dudit compteur obtenue lorsque la tension mesurée entre l'anode (110) et la cathode (111) de la DEL (11) devient inférieure ou égale à la tension seuil prédéfinie (433) étant la valeur représentative d'un temps de décharge de la DEL.

3. Procédé selon la revendication 2, **caractérisé en ce qu'** une valeur de correction est appliquée à la valeur dudit compteur obtenue lorsque la tension mesurée entre l'anode (110) et la cathode (111) de la DEL (11) devient inférieure ou égale à la tension seuil prédéfinie (433), ladite valeur dudit compteur après application de la valeur de correction étant la valeur représentative d'un temps de décharge de la DEL (11), la valeur de correction étant obtenue à partir d'une fonction de correction déterminée en faisant des mesures de capacité d'émission de lumière et des mesures de capacité de captation de lumière sur un ensemble de DEL prédéfini.

4. Procédé selon la revendication 2 ou 3, **caractérisé en ce que** ladite valeur dudit compteur est initialisée à zéro à chaque polarisation en inverse de la DEL (11).

5. Procédé selon la revendication 2, 3 ou 4, **caractérisé en ce que** suite au démarrage du compteur, le compteur est arrêté si un temps écoulé depuis son démarrage atteint une valeur de temps prédéfinie.

6. Procédé selon la revendication 2, 3, 4 ou 5, **caractérisé en ce que** le port cathode et le port anode sont des ports entrée/sortie logiques, et la tension seuil prédéfinie est une tension de commutation du port cathode (1011) d'un état entrée vers un état sortie.

7. Procédé selon l'une quelconque des revendications précédentes, **caractérisé en ce qu'**une procédure de correction est lancée (63) en fonction de l'information représentative de la capacité d'émission de lumière de la DEL (11) déterminée.

8. Procédé selon la revendication 7, **caractérisé en ce que** la procédure de correction signale (631) à un opérateur que la DEL (11) doit être remplacée.

9. Procédé selon la revendication 7, **caractérisé en ce que** la procédure de correction comprend :

déterminer (632) un courant à appliquer à la DEL (11) lorsque la DEL (11) est polarisée en direct, en fonction de la capacité d'émission de lumière de la DEL (11) déterminée, et d'une capacité d'émission de lumière à atteindre ; et, appliquer (633) le courant déterminé à la DEL (11) lorsque la DEL (11) est polarisée en sens direct.

10. Procédé pour homogénéiser une lumière émise par chaque DEL d'une pluralité de DEL (11) d'un dispositif, chaque DEL comportant une cathode (1011) et une anode (1010) reliées à des ports d'un dispositif de contrôle (10), **caractérisé en ce que** le procédé selon l'une quelconque des revendications 1 à 9 est appliqué pour chaque DEL.

11. Procédé selon la revendication 10 lorsque le procédé selon la revendication 9 est appliqué pour chaque DEL, **caractérisé en ce que** la capacité d'émission de lumière à atteindre est une capacité d'émission de lumière déterminée pour une des DEL de la pluralité de DEL (11) sélectionnée selon un critère prédéfini.

12. Procédé selon la revendication 11, **caractérisé en ce que** le critère prédéfini sélectionne la capacité d'émission de lumière déterminée la plus élevée parmi les capacités d'émission de lumière déterminées pour chaque DEL de la pluralité de DEL (11), ou la capacité d'émission de lumière déterminée la plus faible parmi les capacités d'émission de lumière déterminées pour chaque DEL de la pluralité de DEL (11), ou une capacité d'émission de lumière déterminée médiane parmi les capacités d'émission de lumière déterminées pour chaque DEL de la pluralité de DEL (11).

13. Dispositif pour déterminer une capacité d'émission de lumière d'une diode électroluminescente (11), dite DEL, ladite DEL comportant une cathode (111) et une anode (110) reliées à des ports d'un dispositif de contrôle (10), appelés respectivement port cathode (1011) et port anode, **caractérisé en ce que** le dispositif comprend:

des moyens de contrôle pour polariser (41) la DEL (11) en sens inverse de sorte à provoquer une accumulation d'une charge électrique par la DEL (11), ladite DEL (11) étant soumise à une source de lumière incidente à la DEL (11) ;

des moyens de contrôle, pour contrôler (42) le port cathode (1011) et le port anode (1010), pour provoquer une décharge de la charge électrique accumulée par la DEL (11) ;

des moyens d'obtention pour obtenir (43) une valeur représentative d'un temps de décharge de la charge de la DEL (11) ;

des moyens de détermination pour déterminer (44) la capacité d'émission de lumière de la DEL (11) en fonction du temps de décharge obtenu.

14. Programme d'ordinateur, **caractérisé en ce qu'**il comprend des instructions pour mettre en oeuvre, par un dispositif (10), le procédé selon l'une quelconque des revendications 1 à 12, lorsque ledit programme est exécuté par un processeur (101) dudit dispositif (10).

15. Moyens de stockage, **caractérisés en ce qu'**ils stockent un programme d'ordinateur comprenant des instructions pour mettre en oeuvre, par un dispositif (10), le procédé selon l'une quelconque des revendications 1 à 12, lorsque ledit programme est exécuté par un processeur (101) dudit dispositif (10).

**Patentansprüche**

1. Verfahren zur Bestimmung einer Lichtemissionsleistung einer Elektrolumineszenzdiode (11), genannt DEL, wobei die DEL (11) eine Kathode (111) und eine Anode (110) aufweist, die mit Ports einer Steuervorrichtung (10) verbunden sind, die Kathoden-Port (1011) bzw. Anoden-Port (1010) genannt werden, **dadurch gekennzeichnet, dass** das Verfahren die folgenden Schritte enthält:

Vorspannen (41) der DEL (11) in Sperrrichtung, um ein Speichern einer elektrischen Ladung durch die DEL (11) zu bewirken, wobei die DEL einer Quelle auf die DEL (11) einfallenden Lichts ausgesetzt ist;

Steuern des Kathoden-Ports (1011) und des Anoden-Ports (1010), um eine Entladung der von der DEL (11) gespeicherten elektrischen Ladung zu bewirken (42);

Erhalt (43) eines für eine Entladezeit der Ladung der DEL (11) repräsentativen Werts;

Bestimmen (44) der Lichtemissionsleistung der DEL (11) abhängig von der erhaltenen Entladezeit.

2. Verfahren nach Anspruch 1, **dadurch gekennzeichnet, dass** gleichzeitig mit der Steuerung des Kathoden-Ports (1011) und des Anoden-Ports (1010), um eine Entladung der von der DEL (11) gespeicherten elektrischen Ladung zu bewirken, ein Zähler gestartet wird (431), wobei ein Wert des Zählers periodisch um eine Einheit mit einer vordefinierten Periode inkrementiert wird, so lange eine gemessene Spannung zwischen der Anode (110) und der Kathode (111) der DEL (11) höher ist als eine vordefinierte Schwellenspannung (432), wobei der erhaltene Wert des Zählers, wenn die gemessene Spannung zwischen der Anode (110) und der Kathode (111) der DEL (11) niedriger als die oder gleich der vordefinierten Schwellenspannung wird (433), der für eine Entladezeit der DEL repräsentative Wert ist.

3. Verfahren nach Anspruch 2, **dadurch gekennzeichnet, dass** ein Korrekturwert an den Wert des Zählers angewendet wird, der erhalten wird, wenn die gemessene Spannung zwischen der Anode (110) und der Kathode (111) der DEL (11) niedriger als die oder gleich der vordefinierten Schwellenspannung wird (433), wobei der Wert des Zählers nach der Anwendung des Korrekturwerts der für eine Entladezeit der DEL (11) repräsentative Wert ist, wobei der Korrekturwert ausgehend von einer bestimmten Korrekturfunktion erhalten wird, indem Messungen der Lichtemissionsleistung und Messungen der Lichtauffangleistung an einer vordefinierten Einheit von DEL durchgeführt werden.

4. Verfahren nach Anspruch 2 oder 3, **dadurch gekennzeichnet, dass** der Wert des Zählers bei jeder Sperrvorspannung der DEL (11) mit Null initialisiert wird.

5. Verfahren nach Anspruch 2, 3 oder 4, **dadurch gekennzeichnet, dass** nach dem Start des Zählers der Zähler angehalten wird, wenn eine seit seinem Start vergangene Zeit einen vordefinierten Zeitwert erreicht.

6. Verfahren nach Anspruch 2, 3, 4 oder 5, **dadurch gekennzeichnet, dass** der Kathoden-Port und der Anoden-Port logische Eingangs-/Ausgangsports sind, und die vordefinierte Schwellenspannung eine Umschaltspannung des Kathoden-Ports (1011) von einem Eingangszustand in einen Ausgangszustand ist.

7. Verfahren nach einem der vorhergehenden Ansprüche, **dadurch gekennzeichnet, dass** eine Korrekturprozedur abhängig von der für die bestimmte Lichtemissionsleistung der DEL (11) repräsentativen Information gestartet wird (63).

8. Verfahren nach Anspruch 7, **dadurch gekennzeichnet, dass** die Korrekturprozedur einem Betreiber signalisiert (631), dass die DEL (11) ersetzt werden muss.

9. Verfahren nach Anspruch 7, **dadurch gekennzeichnet, dass** die Korrekturprozedur enthält:

   Bestimmen (632) eines an die DEL (11) anzulegenden Stroms, wenn die DEL (11) in Durchlassrichtung vorgespannt ist, abhängig von der bestimmten Lichtemissionsleistung der DEL (11) und von einer zu erreichenden Lichtemissionsleistung; und
   Anlegen (633) des bestimmten Stroms an die DEL (11), wenn die DEL (11) in Durchlassrichtung vorgespannt ist.

10. Verfahren zur Homogenisierung eines von jeder DEL einer Vielzahl von DEL (11) einer Vorrichtung emittierten Lichts, wobei jede DEL eine Kathode (1011) und eine Anode (1010) aufweist, die mit Ports einer Steuervorrichtung (10) verbunden sind, **dadurch gekennzeichnet, dass** das Verfahren nach einem der Ansprüche 1 bis 9 für jede DEL angewendet wird.

11. Verfahren nach Anspruch 10, wenn das Verfahren nach Anspruch 9 für jede DEL angewendet wird, **dadurch gekennzeichnet, dass** die zu erreichende Lichtemissionsleistung eine bestimmte Lichtemissionsleistung für eine der DEL der Vielzahl von DEL (11) ist, die gemäß einem vordefinierten Kriterium ausgewählt wird.

12. Verfahren nach Anspruch 11, **dadurch gekennzeichnet, dass** das vordefinierte Kriterium die höchste bestimmte Lichtemissionsleistung unter den bestimmten Lichtemissionsleistungen für jede DEL der Vielzahl von DEL (11), oder die schwächste bestimmte Lichtemissionsleistung unter den bestimmten Lichtemissionsleistungen für jede DEL der Vielzahl von DEL (11), oder eine mittlere bestimmte Lichtemissionsleistung unter den bestimmten Lichtemissionsleistungen für jede DEL der Vielzahl von DEL (11) auswählt.

13. Vorrichtung zur Bestimmung einer Lichtemissionsleistung einer Elektrolumineszenzdiode (11), genannt DEL, wobei die DEL eine Kathode (111) und eine Anode (110) aufweist, die mit Ports einer Steuervorrichtung (10) verbunden sind, Kathoden-Port (1011) bzw. Anoden-Port genannt, **dadurch ge-**kennzeichnet, dass** die Vorrichtung enthält:

   Steuereinrichtungen zum Vorspannen (41) der DEL (11) in Sperrrichtung, um ein Speichern einer elektrischen Ladung durch die DEL (11) zu bewirken, wobei die DEL (11) einer Quelle auf die DEL (11) einfallenden Lichts ausgesetzt ist;
   Steuereinrichtungen zum Steuern (42) des Kathoden-Ports (1011) und des Anoden-Ports (1010), um eine Entladung der von der DEL (11) gespeicherten elektrischen Ladung zu bewirken;
   Erhaltungseinrichtungen, um einen für eine Entladezeit der Ladung der DEL (11) repräsentativen Wert zu erhalten (43);
   Bestimmungseinrichtungen, um die Lichtemissionsleistung der DEL (11) abhängig von der erhaltenen Entladezeit zu bestimmen (44).

14. Computerprogramm, **dadurch gekennzeichnet, dass** es Anweisungen enthält, um durch eine Vorrichtung (10) das Verfahren nach einem der Ansprüche 1 bis 12 durchzuführen, wenn das Programm von einem Prozessor (101) der Vorrichtung (10) ausgeführt wird.

15. Speichereinrichtungen, **dadurch gekennzeichnet, dass** sie ein Computerprogramm speichern, das Anweisungen enthält, um durch eine Vorrichtung (10) das Verfahren nach einem der Ansprüche 1 bis 12 durchzuführen, wenn das Programm von einem Prozessor (101) der Vorrichtung (10) ausgeführt wird.

## Claims

1. Method for determining a light-emission capacity of a light emitting diode (11), referred to as a LED, said LED (11) comprising a cathode (111) and an anode (110) connected to ports of a control device (10), referred to respectively as cathode port (1011) and anode port (1010), **characterised in that** the method comprises the following steps:

   reverse-biasing (41) the LED (11) so as to cause an accumulation of an electric charge by the LED (11), said LED being subjected to a light source incident to the LED (11);
   controlling the cathode port (101) and the anode port (1010) in order to cause (42) a discharge of the electric charge accumulated by the LED (11);
   obtaining (43) a value representing a time taken for discharging the charge from the LED (11);
   determining (44) the light-emission capacity of the LED (11) as a function of the discharge time obtained.

**2.** Method according to claim 1, **characterised in that**, simultaneously with the control of the cathode port (1011) and anode port (1010) in order to cause a discharge of the electric charge accumulated by the LED (11), a counter is started (431), a value of said counter being incremented periodically by one unit with a predefined period as long as a voltage measured between the anode (110) and the cathode (111) of the LED (11) is greater than a predefined threshold voltage (432), the value of said counter obtained when the voltage measured between the anode (110) and the cathode (111) of the LED (11) becomes less than or equal to the predefined threshold voltage (433) being the value representing a discharge time for the LED.

**3.** Method according to claim 2, **characterised in that** a correction value is applied to the value of said counter obtained when the voltage measured between the anode (110) and the cathode (111) of the LED (11) becomes less than or equal to the predefined threshold value (433), said value of said counter after application of the correction value being the value representing a discharge time for the LED (11), the correction value being obtained from a correction function determined by making light-emission capacity measurements and light-capture capacity measurements on a predefined set of LEDs.

**4.** Method according to claim 2 or claim 3, **characterised in that** said value of said counter is initialised to zero each time the LED (11) is reverse biased.

**5.** Method according to claim 2, 3 or 4, **characterised in that**, following the starting of the counter, the counter is stopped if a time elapsed since the starting thereof reaches a predefined time value.

**6.** Method according to claim 2, 3, 4 or 5, **characterised in that** the cathode port and the anode port are logic input/output ports, and the predefined threshold voltage is a voltage for switching the cathode port (1011) from an input state to an output state.

**7.** Method according to any of the preceding claims, **characterised in that** a correction procedure is initiated (63) according to the information representing the light-emission capacity of the LED (11) determined.

**8.** Method according to claim 7, **characterised in that** the correction procedure signals (631) to an operator that the LED (11) must be replaced.

**9.** Method according to claim 7, **characterised in that** the correction procedure comprises:

 determining (632) a current to be applied to the LED (11) when the LED (11) is direct biased, according to the light-emission capacity of the LED determined, and a light-emission capacity to be achieved; and
applying (633) the current determined to the LED (11) when the LED (11) is direct biased.

**10.** Method for homogenising light emitted by each LED in a plurality of LEDs (11) of a device, each LED comprising a cathode (1011) and an anode (1010) both connected to ports of a control device (10), **characterised in that** the method according to any of claims 1 to 9 is applied for each LED.

**11.** Method according to claim 10 when the method according to claim 9 is applied for each LED, **characterised in that** the light-emission capacity to be achieved is a light-emission capacity determined for one of the LEDs in the plurality of LEDs (11) selected according to a predefined criterion.

**12.** Method according to claim 11, **characterised in that** the predefined criterion selects the light-emission capacity determined as being the highest among the light-emission capacities determined for each LED in the plurality of LEDs (11), or the light-emission capacity determined as being the lowest among the light-emission capacities determined for each LED in the plurality of LEDs (11), or a light-emission capacity determined as being median among the light-emission capacities determined for each LED in the plurality of LEDs (11).

**13.** Device for determining a light-emission capacity of a light emitting diode (11), referred to as a LED, said LED comprising a cathode (111) and an anode (110) connected to ports of a control device (10), referred to respectively as cathode port (1011) and anode port, **characterised in that** the device comprises:

 control means for biasing (41) the LED (11) in the reverse direction so as to cause an accumulation of an electric charge by the LED (11), said LED (11) being subjected to a source of light incident to the LED (11);
control means for controlling (42) the cathode port (1011) and the anode port (1010) in order to cause a discharge of the electric charge accumulated by the LED (11);
obtaining means for obtaining (43) a value representing a time taken for discharging the charge from the LED (11);
determination means for determining (44) the light-emission capacity of the LED (11) according to the discharge time obtained.

**14.** Computer program, **characterised in that** it comprises instructions for the implementation, by a device (10), of the method according to any of claims 1 to 12, when said program is executed by a processor (101) of said device (10).

15. Storage means, **characterised in that** they store a computer program comprising instructions for the implementation, by a device (10), of the method according to any of claims 1 to 12, when said program is executed by a processor (101) of said device (10).

Contrôle

DEL

1

10

11

## Fig. 1

101
CPU

102
RAM

103
ROM

10

100

HDD
104

COM
105

## Fig. 2

1010

110

11

111

CPU

101

1011

12

## Fig. 3

Application
tension inverse
DEL ⎯ 41

Provoquer
décharge DEL ⎯ 42

Obtenir temps de
décharge ⎯ 43

Déterminer
capacité
d'émission de
lumière en
fonction du temps
de décharge ⎯ 44

Fig. 4

Démarrage
compteur ⎯431

Tension LED < $S_v$
? ⎯432

Arrêt compteur ⎯433

Sauvegarde temps
de décharge ⎯434

Fig. 5

Obtention d'une information représentative d'une capacité d'émission de lumière — 61

Mesure corrective nécessaire? — 62

Lancement procédure de correction — 63

Pas de correction — 64

Fig. 6

Signalisation de changement de DEL — 631

Fig. 7A

Détermination d'une valeur de courant — 632

Application de la valeur de courant déterminée — 633

Fig. 7B